# EUROPEAN PATENT APPLICATION

(11) **EP 4 332 995 A1**
(43) Date of publication of application: **06.03.2024**
(21) Application number: 22795667.9
(22) Date of filing: 21.04.2022
(51) Int. Cl.: H01B 5/14, B32B 9/00

(54) **LAYERED BODY HAVING FUNCTION AS TRANSPARENT ELECTROCONDUCTIVE FILM AND METHOD FOR PRODUCING SAME, AND OXIDE SPUTTERING TARGET FOR SAID LAYERED BODY PRODUCTION**

(30) Priority: 27.04.2021 JP 2021074650; 01.02.2022 JP 2022014394
(71) Applicant: JX Metals Corporation, Tokyo 105-8417 (JP)
(72) Inventor: NARA, Atsushi, Kitaibaraki-shi, Ibaraki 319-1535 (JP)
(74) Representative: Forresters IP LLP
(86) International application number: PCT/JP2022/018417
(87) International publication number: WO 2022/230754

(57) **Abstract**

Provided is a layered body having lower resistivity (higher conductivity) and higher transmittance than conventional ITO films. A layered body obtained by layering an ITO film and an oxide film, wherein the layered body has a surface resistance of 40 Ω/sq. or less and a visible light average transmittance of 90% or higher, and a ratio of a film thickness of the ITO film and a film thickness of the oxide film (film thickness of the ITO film/film thickness of the oxide film) is less than 15. A layered body obtained by layering an ITO film and an oxide film, wherein R2/R1≤1.0 is satisfied when a surface resistance of the layered body that underwent atmosphere annealing at 220°C is R1, and a surface resistance of the layered body that underwent atmosphere annealing at 550°C is R2.

## Description

### [Technical Field]

The present invention relates to a layered body having a function as a transparent electroconductive film, a method for producing the layered body, and an oxide sputtering target for producing the layered body.

### [Background Art]

ITO (Indium-Tin-Oxide) films are used across a broad range of fields, including display electrodes for flat panel displays, since they exhibit characteristics such as low resistivity, high transmittance and ease of microfabrication, and these characteristics are superior to those of other transparent electroconductive films. Today, since many of the ITO films for industrial use have superior large-area uniformity and can be produced with favorable productivity, they are produced based on the so-called sputter deposition method of depositing films using an ITO sintered body as the sputtering target.

Since an ITO film will become a low-resistant, transparent film by being crystallized, annealing is performed at roughly 220 to 250°C after deposition. Meanwhile, films having low resistivity and high transmittance are desired, and annealing at a temperature of 300°C or higher is also being attempted. Nevertheless, when annealing is performed, while transmittance will improve, resistivity will increase, and, as it stands now, films comprising both lower resistivity and higher transmittance have not been realized. The present applicant has previously proposed a technology capable of forming low resistance ITO films at a low temperature (for example, Patent Document 1).

### [Prior Art Documents]

### [Patent Documents]

[Patent Document 1] Japanese Unexamined Patent Application Publication No. 2020-164930

### [Disclosure of the Invention]

### [Problems to be Solved by the Invention]

An object of the present invention is to provide a layered body having lower resistivity (surface resistance) and higher transmittance than ITO films.

### [Means for Solving the Problems]

In order to achieve the foregoing object, as a result of intense study, the present inventors discovered that, by preparing a layered body by layering a specific oxide film on an ITO film, high transmittance can be maintained while preventing the increase in resistivity (surface resistance) caused by annealing. Based on this kind of discovery, the present disclosure provides the following modes of the present invention.

One mode of the present invention is a layered body obtained by layering an oxide film on an ITO film, wherein the layered body has a surface resistance of 40 Ωcm/sq. or less and a visible light average transmittance of 90% or higher, and a ratio of a film thickness of the ITO film and a film thickness of the oxide film (film thickness of the ITO film/film thickness of the oxide film) is less than 15.

Another mode of the present invention is a layered body obtained by layering an ITO film and an oxide film, wherein R2/R1≤1.0 is satisfied when a surface resistance of the layered body that underwent atmosphere annealing at 220°C is R1, and a surface resistance of the layered body that underwent atmosphere annealing at 550°C is R2.

Moreover, another mode of the present invention is a layered body obtained by layering an ITO film and an oxide film, wherein the oxide film contains Zn in an amount of 0 mol% or more and less than 69 mol% in terms of ZnO, Ga in an amount of 9 mol% or more and 100 mol% or less in terms of Ga₂O₃, and Si in an amount of 0 mol% or more and less than 60 mol% in terms of SiO₂, a film thickness of the oxide film is less than 90 nm, and a ratio of a film thickness of the ITO film and a film thickness of the oxide film (film thickness of the ITO film/film thickness of the oxide film) is less than 15.

Furthermore, another mode of the present invention is an oxide sputtering target containing Zn in an amount of more than 10 mol% and less than 60 mol% in terms of ZnO, Ga in an amount of 10 mol% or more and 60 mol% or less in terms of Ga₂O₃, and Si in an amount of 25 mol% or more and less than 50 mol% in terms of SiO₂.

### [Effect of the Invention]

The layered body according to the present invention comprises superior characteristics, specifically lower resistivity (surface resistance) and higher high transmittance, than ITO films. Moreover, by layering a specific oxide film on an ITO film, a transparent electroconductive film (layered body) comprising favorable characteristics can be provided easily.

### [Brief Description of the Drawings]

[Fig. 1]

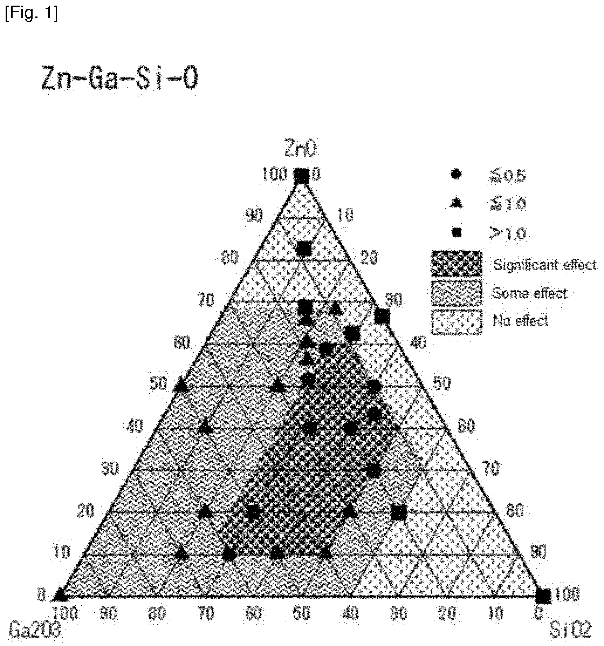

Fig. 1 is an assembly drawing showing the relationship of the composition corresponding to the oxide film (Zn-Ga-Si-O) in the layered body of this embodiment and the effect of the present invention.

### [Best Mode for Carrying Out the Invention]

ITO films having indium (In), tin (Sn), and oxygen (O) as their main components are used for a broad range of applications, including use in flat panel displays, since they exhibit characteristics such as low resistivity, high transmittance and ease of microfabrication, and these characteristics are superior to those of other transparent electroconductive films. Meanwhile, lower resistivity and higher transmittance of ITO films are demanded, and attempts for improving characteristics, such as adding other elements, are being performed continuously.

Since an ITO film will become a low-resistant, transparent film by being crystallized, annealing is performed at roughly 220 to 250°C after deposition. Here, while transmittance can be improved by performing annealing at a higher temperature (300°C or higher), the resistivity will increase. This is considered to be because the carrier concentration of the ITO film will deteriorate during the high temperature annealing. Accordingly, the present inventors considered that it may be possible to prevent the increase of resistivity by layering an oxide film on an ITO film in order to suppress the deterioration in the carrier concentration caused by the high temperature annealing.

As a result of intense study, the present inventors discovered that, by forming a specific oxide film on an ITO film, it is possible to maintain high transmittance while suppressing the deterioration in the carrier concentration and prevent the increase in the resistivity caused by annealing. Embodiments of the present invention are now explained in detail.

In the present specification, an ITO film is composed of oxides containing In and Sn, and, while there is no particular limitation to the composition range thereof, for example, it is possible to use ITO containing Sn in an amount of 50 wt% (approximately 65 mol%) or less in terms of SnO₂, and the remainder being In and unavoidable impurities.

The first embodiment is a layered body obtained by layering an oxide film on an ITO film, wherein the layered body has a surface resistance of 40 Ω/sq. or less and a visible light average transmittance of 90% or higher. The layered body of this embodiment yields a superior effect of being able to achieve lower resistivity and higher transmittance in comparison to ITO films (single films). The surface resistance is preferably 30 Ω/sq. or less, and more preferably 20 Ω/sq. or less. Moreover, the visible light average transmittance is preferably 93% or higher. Note that, since the surface resistance and transmittance will change depending on the annealing temperature, so as long as the foregoing surface resistance and transmittance can be attained irrespective of the annealing temperature of the layered body, they are covered by the layered body of this embodiment.

In the first embodiment, a film thickness of the oxide film layered on the ITO is less than 90 nm, preferably 70 nm or less, and more preferably 50 nm or less. If the film thickness is too thick, the resistivity of the layered body may increase. Meanwhile, if the film thickness is too thin, it may not be possible to sufficiently suppress the deterioration in the carrier concentration of the ITO film, and thus the film thickness is preferably 10 nm or more. Since the effect of suppressing the deterioration in the carrier concentration and the transmittance will be affected by the composition of the oxide film, the film thickness may be adjusted by giving consideration to the composition of the oxide film.

In the first embodiment, a ratio of a film thickness of the ITO film and a film thickness of the oxide film (film thickness of the ITO film/film thickness of the oxide film) is less than 15, and preferably 10 or less. While the surface roughness of the ITO film will increase when the ITO film is crystallized, the surface roughness will increase as the film thickness becomes thicker. This is because, when the film thickness of the oxide film is too thin relative to the surface roughness of the ITO film, it may not be possible to sufficiently suppress the deterioration in the carrier concentration of the ITO film.

The layered body according to the second embodiment is a layered body obtained by layering an ITO film and an oxide film, wherein R2/R1≤1.0 is satisfied when a surface resistance of the layered body that underwent atmosphere annealing at 220°C is R1, and a surface resistance of the layered body that underwent atmosphere annealing at 550°C is R2. The layered body of this embodiment yields a superior effect of being able to achieve lower resistivity and higher transmittance in comparison to ITO films (single films). Preferably, R2/R1≤0.5 is satisfied. In the case of an ITO single film (film thickness of 100 nm), R2/R1 is roughly 1.53, and the layered body of this embodiment yields a superior effect of being able to suppress the increase of the resistivity even when the annealing temperature is increased.

The layered body according to this embodiment can be used as a transparent electroconductive film and, in such a case, high transmittance is demanded. The layered body according to this embodiment preferably has a visible light average transmittance of 85% or higher when it is annealed at 220°C in the atmosphere, and preferably has a visible light average transmittance of 90% or higher when it is annealed at 550°C in the atmosphere.

The layered body according to this embodiment preferably satisfies n1>n2 when a refractive index of the ITO film is n1, and a refractive index of the oxide film is n2. By layering an oxide film, which has a lower refractive index than an ITO film, on an ITO film, it is possible to reduce the reflectance and improve the transmittance. It is thereby possible to obtain a layered body suitable for use as a transparent electroconductive film.

In the layered body according to this embodiment, while there is no particular limitation to the oxide film to be layered on the ITO film so as long as it is a film that can prevent the deterioration in the carrier concentration of the ITO film, it preferably contains one or more types among Zn, Ga, and Si. While it could be said that the ITO film is in itself an oxide film, the oxide film in the present specification does not include an ITO film having the same composition as the base film.

The layered body according to the third embodiment is a layered body obtained by layering an ITO film and an oxide film, wherein the oxide film contains Zn in an amount of 0 mol% or more and less than 69 mol% in terms of ZnO, Ga in an amount of 9 mol% or more and 100 mol% or less in terms of Ga₂O₃, and Si in an amount of 0 mol% or more and less than 60 mol% in terms of SiO₂. The layered body of this embodiment yields a superior effect of being able to achieve lower resistivity and higher transmittance in comparison to ITO films (single films).
Preferably, the layered body of this embodiment contains Zn in an amount of more than 10 mol% and less than 60 mol% in terms of ZnO, Ga in an amount of 10 mol% or more and 60 mol% or less in terms of Ga₂O₃, and Si in an amount of 25 mol% or more and less than 50 mol% in terms of SiO₂.

In the layered body according to this embodiment, the oxide film is preferably in an amorphous state. When the layered body of this embodiment is annealed, the ITO film will become crystallized, but the layered oxide film will maintain its amorphous state, and it is considered that the maintenance of this amorphous state considerably contributes to suppressing the increase of the resistivity.

The method of producing the layered body according an embodiment of the present invention is now specifically explained. The following is merely an exemplification, and there is no intention of limiting the production method to the following example, and other methods may also be adopted as the method of producing the layered body itself. In order to avoid the disclosed production method from becoming unclear unnecessarily, the detailed explanation of known production processes and handling operations is omitted.

An ITO sputtering target composed of oxides containing In and Sn, and a Zn-Ga-Si-O sputtering target composed of oxides containing Zn, Ga, and Si, are prepared. Foremost, the ITO sputtering target is mounted in a vacuum chamber of a sputtering system, and a film is deposited on a substrate facing the sputtering target. Subsequently, the Zn-Ga-Si-O sputtering target is used to form an oxide film on the ITO film deposited on the substrate. The film thickness of the ITO film and the oxide film can be adjusted based on the sputtering power and the sputtering time.

With the sputtering method, since deposition is performed in a vacuum, under normal circumstances, the composition of the sputtering target is reflected in the composition of the film without any loss of metal components configuring the sputtering target or inclusion of other metal compositions during the deposition process. As described later, the composition of the sputtering target is indicated in the Examples and Comparative Examples as a matter of convenience.

The sputtering conditions may be set, for example, as follows. The sputtering conditions may be changed as needed depending on the intended film thickness and composition.

### (Sputtering conditions)

Sputtering system: C-7500L manufactured by ANELVA
Sputtering power: DC500 to 1000 W

### (Targets that cannot undergo DC sputtering are RF500 to 1000 W)

Gas pressure: 0.5 Pa
Substrate heating: Room temperature
Oxygen concentration: 0%, 1%, 2%

Subsequently, after removing the layered body obtained by forming a prescribed oxide film on an ITO film from the sputtering system, annealing is performed at 200 to 600°C in the atmosphere to crystallize the ITO film. The annealing temperature can be decided as needed by giving consideration to the intended resistivity and transmittance, and the heatproof temperature of the base material. The annealing atmosphere is not limited to the atmosphere, and it may also be a vacuum or a nitrogen atmosphere. The layered body according to this embodiment can thereby be produced.

As the sputtering target to be used for forming the oxide film, while a sputtering target having the same composition as the oxide film may be used, a film may also be deposited based on co-sputtering by using two or more types of sputtering targets. While a Zn-Ga-Si-O sputtering target was illustrated above, it is also possible to use a Zn-Ga-O sputtering target, a Zn-Si-O- sputtering target, a Ga-Si-O sputtering target, a ZnO sputtering target, a Ga₂O₃ sputtering target, a SiO₂ sputtering target or the like. Moreover, while sputtering is a method suitable for the deposition of an oxide film, other chemical or physical deposition methods may also be used.

Moreover, the sputtering target to be used in forming the oxide film may also include, as a sintering additive, B₂O₃, P₂O₅, V₂O₅, Sb₂O₃, TeO₂, TI₂O₃, PbO, Bi₂O₃, or MoO₃. These sintering additives are low-melting point oxides, and a dense sintered body (sputtering target) can be produced even when the sintering temperature is lowered. While there is no particular limitation to the additive amount of the sintering additive, the additive amount of the sintering additive is preferably 0.5 wt% or higher and 3.0 wt% or less relative to the basic composition of the target to be used for forming the oxide film. This is because, when the additive amount of the sintering additive is less than 0.5 wt%, the effect of addition as the sintering additive will be weak, and when the additive amount of the sintering additive exceeds 3.0 wt%, it may influence the characteristics of the oxide film. When the additive amount of the sintering additive is 0.5 wt% or higher and 3.0 wt% or less, low temperature sintering is enabled while maintaining the favorable characteristics of the oxide film.

In the present specification, the characteristics of the layered body were evaluated in the following manner.

### (Surface resistance of the film)

The surface resistance of the layered body, which was obtained by layering an oxide film on an ITO film, was measured from the oxide film side.
System: Constant current application system
Device: Resistivity meter Σ-5+ manufactured by NPS
Method: DC 4-point probe method
In the case of high resistivity (100k Ω/sq. or more)
System: Constant voltage application system
Device: High resistivity meter Hiresta-UX manufactured by Mitsubishi Chemical
Analytech
Method: MCC-A method (JISK6911)
Ring electrode probe: URS
Measuring voltage: 1 to 1000 V

### (Transmittance of the film)

The transmittance of the layered body, which was obtained by layering an oxide film on an ITO film, was measured from the oxide film side.
Visible light average transmittance
Device: Spectrophotometer UV-2450, UV-2600 manufactured by SHIMADZU
Reference: Undeposited glass substrate (EagleXG)
Measuring wavelength: 380 to 780 nm
Step: 5 nm

### (Film thickness)

Device: Stylus profiler DektakXT manufactured by BRUKER

### (Refractive index of the film)

Device: Spectrophotometer UV-2450 manufactured by SHIMADZU
Method: Calculated from transmittance and back-surface reflectance

### (Carrier concentration and carrier mobility of the film)

The carrier concentration and the carrier mobility of the layered body, which was obtained by layering an oxide film on an ITO film, was measured from the oxide film side.
Principle: Hall measurement
Device: LakeShore 8400 Series

### (Crystallinity, amorphous state of the film)

In the X-ray diffraction spectrum, the film was determined to be a crystalline film when a clear diffraction peak resulting from the film material was confirmed, and the film was determined to be an amorphous film when a clear diffraction peak could not be observed, and only a halo pattern was visible.
Principle: X-ray diffraction method
Device: UltimalV manufactured by Rigaku
Tube: Cu-Kα rays
Tube voltage: 40 kV
Tube current: 30 mA
Measuring method: 2θ-θ reflection method
Measuring range: 20 to 90°
Scanning speed: 8°/min
Sampling interval: 0.02°
Measurement sample: Film surface of a single film having a film thickness of 300 nm or more was measured.

### [Examples]

The present invention is now explained based on the following Examples and Comparative Examples. Note that the following Examples are merely representative examples, and the present invention is not limited to these Examples in any way. In other words, the present invention is limited only based on the scope of its claims, and covers various modifications other than the Examples included in the present invention.

### (Reference Example)

An ITO sintered body sputtering target configured from In₂O₃:90 wt% (83 mol%), SnO₂:10 wt% (17 mol%) was mounted on a sputtering system, sputtering was performed based on the conditions described above, and an ITO film having a film thickness of 100 nm was formed on a substrate. Subsequently, annealing was performed for 30 minutes in the atmosphere at different temperatures of 220°C and 550°C. The surface resistance and the visible light average transmittance of the thus obtained ITO film were measured. The results are shown in Table 1. Note that "as-depo" in Table 1 indicates that the film was not annealed after deposition.

From Table 1, it can be understood that, when the ITO film is annealed at 220°C, the ITO film became crystallized and the surface resistance deteriorated drastically, but when the ITO film is annealed at 550°C, the surface resistance increased. With this ITO film, R2/R1 is exceeding 1.0, and, when compared to low temperature annealing (220°C), the surface resistance has increased in the case of high temperature annealing (550°C). Meanwhile, when the annealing temperature is set to 550°C, the transmittance improved to 90% or higher.

### (Example 1)

A sputtering target configured from a Zn-Ga-Si-O sintered body was mounted on a sputtering system, sputtering was performed based on the conditions described above, and an oxide film (Zn-Ga-Si-O) having a film thickness of 20 nm was layered on an ITO film (film thickness of 100 nm) that was prepared based on the same conditions as the Reference Example. The composition (in terms of oxide) of the sputtering target was set to be ZnO:Ga₂O₃, SiO₂=40:20:40 (mol%). Subsequently, annealing was performed for 30 minutes in the atmosphere at different temperatures of 220°C and 550°C. The surface resistance and the visible light average transmittance of the thus obtained layered body were measured. The results are shown in Table 1.

As shown in Table 1, when the layered body is annealed at 220°C, the ITO film became crystallized and the resistivity deteriorated drastically. Meanwhile, unlike the ITO film (single film), the resistivity deteriorated when the layered body was annealed at 550°C. R2/R1 exceeded 1.0 considerably, and it can be understood that the surface resistance deteriorates considerably with high temperature annealing (550°C). Moreover, when the annealing temperature is set to 550°C, the transmittance improved to 90% or higher. By producing a layered body obtained by layering an ITO film and an oxide film in the manner described above, low resistivity and high transmittance, which could not be obtained with conventional ITO films, can be realized.

### (Examples 2 to 23)

As with Example 1, an oxide film (Zn-Ga-Si-O) having a film thickness of 20 nm was layered on an ITO film (film thickness of 100 nm). In each of the Examples, as shown in Table 1, the composition (in terms of oxide) of the sputtering target and the oxygen concentration at the time of deposition were adjusted. Moreover, in Examples 22 and 23, 1.0 wt% of B₂O₃ was added as a sintering additive to the sputtering target. Subsequently, annealing was performed for 30 minutes in the atmosphere at different temperatures of 220°C and 550°C. The surface resistance and the visible light average transmittance of the thus obtained layered body were measured. The results are shown in Table 1.

As shown in Table 1, when the layered body is annealed at a certain temperature or higher, the ITO film became crystallized and the surface resistance deteriorated drastically. Meanwhile, unlike the ITO film (single film), the surface resistance deteriorated when the layered body was annealed at 550°C. R2/R1 exceeded 1.0 considerably, and it can be understood that the surface resistance deteriorates considerably with high temperature annealing (550°C). Moreover, when the annealing temperature is set to 550°C, the transmittance improved to 90% or higher. Furthermore, in all of the layered bodies, the oxide film maintained its amorphous state. By producing a layered body obtained by layering an ITO film and an oxide film in the manner described above, low resistivity and high transmittance, which could not be obtained with ITO films (single films), can be realized.

### (Comparative Examples 1 to 4)

As with Example 1, an oxide film (Zn-Ga-Si-O) having a film thickness of 20 nm was layered on an ITO film (film thickness of 100 nm). In each of the Comparative Examples, as shown in Table 1, the composition (in terms of oxide) of the sputtering target and the oxygen concentration at the time of deposition were adjusted. Subsequently, annealing was performed for 30 minutes in the atmosphere at different temperatures of 220°C and 550°C. The surface resistance and the visible light average transmittance of the thus obtained layered body were measured. The results are shown in Table 1.

As shown in Table 1, when the layered body is annealed at 220°C, the ITO film became crystallized and the surface resistance deteriorated drastically. Meanwhile, the surface resistance increased when the layered body was annealed at 550°C. In the Comparative Example, R2/R1 exceeded 1.0 in all cases, and, in comparison to low temperature annealing (220°C), it can be understood that the surface resistance increases with high temperature annealing (550°C). Meanwhile, when annealing is performed at 550°C, the transmittance improved to 90% or higher.

The composition diagram showing the relationship of the composition of the sputtering target (corresponds to the composition of the oxide film) and the effect of the present invention (low resistance and high transmittance) in Examples 1 to 21 and Comparative Examples 1 to 4 is shown in Fig. 1.

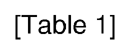

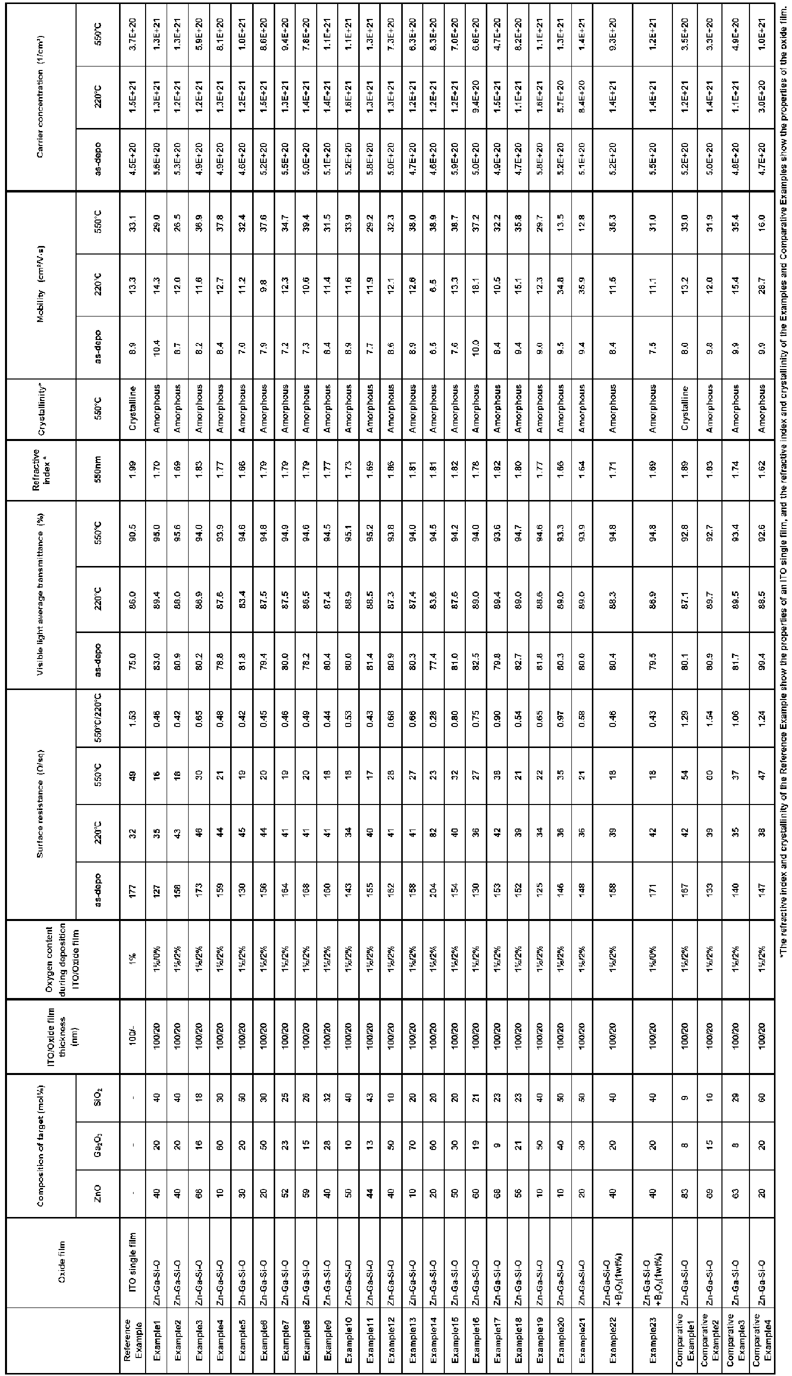

### (Examples 24 and 25)

A sputtering target configured from the various oxide sintered bodies of Table 2 was mounted on a sputtering system, sputtering was performed based on the conditions described above, and an oxide film having a film thickness of 20 nm was layered on an ITO film (film thickness of 100 nm) that was prepared based on the same conditions as the Reference Example. Here, the composition (in terms of oxide) of the sputtering target was changed as shown in Table 2. Subsequently, annealing was performed for 30 minutes in the atmosphere by changing the temperature. The surface resistance and the visible light average transmittance of the thus obtained layered body were measured. The results are shown in Table 2. Note that "as-depo" in Table 1 indicates that the film was not annealed after deposition.

As shown in Table 2, when the layered body is annealed at 220°C, the ITO film became crystallized and the resistivity deteriorated drastically. Meanwhile, unlike the ITO film (single film), the surface resistance deteriorated when the layered body was annealed at 550°C. R2/R1 exceeded 1.0 considerably, and it can be understood that the surface resistance deteriorates considerably with high temperature annealing (550°C). Moreover, when the annealing temperature is set to 550°C, the transmittance improved to 90% or higher. Furthermore, in all of the layered bodies, the oxide film maintained its amorphous state. By producing a layered body obtained by layering an ITO film and an oxide film in the manner described above, low resistivity and high transmittance, which could not be obtained with ITO films (single films), can be realized.

### (Comparative Examples 5 to 10)

A sputtering target configured from the various oxide sintered bodies [of Table 2] was mounted on a sputtering system, sputtering was performed based on the conditions described above, and an oxide film having a film thickness of 20 nm was layered on an ITO film (film thickness of 100 nm) that was prepared based on the same conditions as the Reference Example. Here, the composition (in terms of oxide) of the sputtering target was changed as shown in Table 2. Subsequently, annealing was performed for 30 minutes in the atmosphere by changing the temperature. The surface resistance and the visible light average transmittance of the thus obtained layered body were measured. The results are shown in Table 2.

As shown in Table 2, when the layered body is annealed at 220°C, the ITO film became crystallized and the surface resistance deteriorated drastically. Meanwhile, the surface resistance increased when the layered body was annealed at 550°C. In the Comparative Example, R2/R1 exceeded 1.0 in all cases, and, in comparison to low temperature annealing (220°C), it can be understood that the surface resistance increases with high temperature annealing (550°C). Meanwhile, when the annealing temperature is set to 550°C, the transmittance improved to 90% or higher.

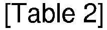

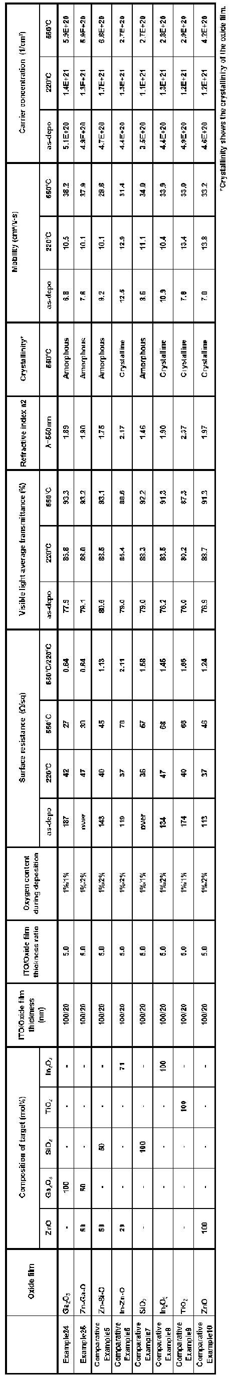

### (Examples 26 to 34)

A sputtering target configured from a Zn-Ga-Si sintered body was mounted on a sputtering system, sputtering was performed based on the conditions described above, and an oxide film was layered on an ITO film that was prepared based on the same conditions as the Reference Example. Here, in each of the Examples, the film thickness of the ITO film and the film thickness of the oxide film were changed. The composition (in terms of oxide) of the sputtering target was set to be ZnO:Ga₂O₃, SiO₂=40:20:40 (mol%). Subsequently, annealing was performed for 30 minutes in the atmosphere by changing the temperature. The surface resistance and the visible light average transmittance of the thus obtained layered body were measured. The results are shown in Table 3. Note that "as-depo" in Table 1 indicates that the film was not annealed after deposition.

As shown in Table 3, when the layered body is annealed at 220°C, the ITO film became crystallized and the surface resistance deteriorated drastically. Meanwhile, unlike the ITO film (single film), the surface resistance deteriorated when the layered body was annealed at 550°C. R2/R1 exceeded 1.0 considerably, and it can be understood that the resistivity deteriorates considerably with high temperature annealing (550°C). Moreover, when the annealing temperature is set to 550°C, the transmittance improved to 90% or higher. Furthermore, in all of the layered bodies, the oxide film maintained its amorphous state. By producing a layered body obtained by layering an ITO film and an oxide film in the manner described above, low resistivity and high transmittance, which could not be obtained with ITO films (single films), can be realized.

### (Comparative Examples 11 and 12)

A sputtering target configured from a Zn-Ga-Si sintered body was mounted on a sputtering system, sputtering was performed based on the conditions described above, and an oxide film was layered on an ITO film that was prepared based on the same conditions as the Reference Example. Here, in each of the Comparative Examples, the film thickness of the ITO film and the film thickness of the oxide film were changed. Note that the composition (in terms of oxide) of the sputtering target was set to be ZnO:Ga₂O₃, SiO₂=40:20:40 (mol%). Subsequently, annealing was performed for 30 minutes in the atmosphere by changing the temperature. The surface resistance and the visible light average transmittance of the thus obtained layered body were measured. The results are shown in Table 3.

As shown in Table 3, when the layered body is annealed at 220°C, the ITO film became crystallized and the surface resistance deteriorated drastically. Meanwhile, the surface resistance increased when the layered body was annealed at 550°C. In the Comparative Example, R2/R1 exceeded 1.0 in all cases, and, in comparison to low temperature annealing (220°C), it can be understood that the surface resistance increases with high temperature annealing (550°C). Meanwhile, when the annealing temperature is set to 550°C, the transmittance improved to 90% or higher.

**[Table 3]**

| | Oxide film | Composition of target (mol%) | | | ITO/Oxide film thickness (nm) | ITO/Oxide film thickness ratio | Oxygen content during deposition | Surface resistance (Ω/sq) | | | | Visible light average transmittance (%) | | | Refractive index n2 | Crystallinity. |
|---|---|---|---|---|---|---|---|---|---|---|---|---|---|---|---|---|
| | | ZnO | Ga₂O₃ | SiO₂ | | | | as-depo | 220°C | 550°C | 550°C1220°C | as-depo | 220°C | 550°C | λ=550nm | 550°C |
| Example26 | Zn-Ga-Si-O | 40 | 20 | 40 | 100/10 | 10.0 | 1%/2% | 167 | 41 | 22 | 0.54 | 78.4 | 87.0 | 93.6 | 1.69 | Amorphous |
| Example27 | Zn-Ga-Si-O | 40 | 20 | 40 | 100/20 | 5.0 | 1%/2% | 168 | 43 | 18 | 0.42 | 80.9 | 88.0 | 95.6 | 1.69 | Amorphous |
| Example28 | Zn-Ga-Si-O | 40 | 20 | 40 | 100/30 | 3.3 | 1%/2% | 173 | 39 | 17 | 0.44 | 79.2 | 86.3 | 95.1 | 1.69 | Amorphous |
| Example29 | Zn-Ga-Si-O | 40 | 20 | 40 | 700140 | 2.5 | 1%/2% | 164 | 4.7E+10 | 17 | 0.00 | 81.7 | 87.2 | 95.7 | 1.69 | Amorphous |
| Example30 | Zn-Ga-Si-O | 40 | 20 | 40 | 150/30 | 5.0 | 1%/0% | 149 | 35 | 11 | 0.31 | 762 | 78.8 | 93.3 | 1.70 | Amorphous |
| Example31 | Zn-Ga-Si-O | 40 | 20 | 40 | 200120 | 10.0 | 1%/0% | 120 | 25 | 13 | 0.52 | 68.1 | 73.3 | 91.9 | 1.70 | Amorphous |
| Example32 | Zn-Ga-Si-O | 40 | 20 | 40 | 200/40 | 5.0 | 1%/0% | 113 | 28 | 9 | 0.32 | 70.2 | 76.2 | 91.8 | 1.70 | Amorphous |
| Example33 | Zn-Ga-Si-O | 40 | 20 | 40 | 300/40 | 7.6 | 1%/0% | 98 | 19 | 18 | 0.95 | 100 | 77.1 | 93.8 | 1.70 | Amorphous |
| Example34 | Zn-Ga-Si-0 | 40 | 20 | 40 | 50120 | 2.5 | 1%/0% | 295 | 82 | 35 | 0.43 | 77.7 | 85.9 | 90.2 | 1.70 | Amorphous |
| Comparative Example11 | Zn-Ga-Si-O | 40 | 20 | 40 | 100180 | 1.1 | 1%/2% | 2.2E+08 | 3.6E-10 | 5.3E+06 | - | 829 | 85.9 | 94.3 | 1.69 | Amorphous |
| Comparative Example12 | Zn-Ga-Si-O | 40 | 20 | 40 | 300/20 | 15.0 | 1%/0% | 104 | 21 | 31 | 1.48 | 68.7 | 76.8 | 90.1 | 1.70 | Amorphous |

| | | | | | | | | | | | | | | | | |
|---|---|---|---|---|---|---|---|---|---|---|---|---|---|---|---|---|
| *Crystallinity shows the crystallinity of the oxide film. | | | | | | | | | | | | | | | | |

### [Industrial Applicability]

The layered body of the present invention can obtain superior characteristics, specifically lower resistivity and higher transmittance, in comparison to ITO films (single films). Moreover, the present invention yields a superior effect of being able to provide a transparent electroconductive film (layered body) comprising favorable characteristics easily by layering [an oxide film] on an ITO film. The layered body according to the present invention is particularly useful as a transparent electroconductive film in a device (flat panel display, micro LED or the like) using a glass substrate or a Si substrate that can be annealed at a high temperature.

## Claims

1. A layered body obtained by layering an ITO film and an oxide film, wherein the layered body has a surface resistance of 40 Ω/sq. or less and a visible light average transmittance of 90% or higher, and a ratio of a film thickness of the ITO film and a film thickness of the oxide film (film thickness of the ITO film/film thickness of the oxide film) is less than 15.

2. A layered body obtained by layering an ITO film and an oxide film, wherein R2/R1≤1.0 is satisfied when a surface resistance of the layered body that underwent atmosphere annealing at 220°C is R1, and a surface resistance of the layered body that underwent atmosphere annealing at 550°C is R2.

3. The layered body according to claim 2,
wherein a ratio of the surface resistance R1 and the surface resistance R2 is R2/R1≤0.5.

4. The layered body according to any one of claims 1 to 3,
wherein the visible light average transmittance of the layered body that underwent atmosphere annealing at 220°C is 85% or higher.

5. The layered body according to any one of claims 1 to 3,
wherein the visible light average transmittance of the layered body that underwent atmosphere annealing at 550°C is 90% or higher.

6. The layered body according to any one of claims 1 to 5,
wherein n1>n2 is satisfied when a refractive index of the ITO film is n1, and a refractive index of the oxide film is n2.

7. The layered body according to any one of claims 1 to 6,
wherein the oxide film includes one of more types among Zn, Ga, and Si.

8. A layered body obtained by layering an ITO film and an oxide film, wherein the oxide film contains Zn in an amount of 0 mol% or more and less than 69 mol% in terms of ZnO, Ga in an amount of 9 mol% or more and 100 mol% or less in terms of Ga₂O₃, and Si in an amount of 0 mol% or more and less than 60 mol% in terms of SiO₂, a film thickness of the oxide film is less than 90 nm, and a ratio of a film thickness of the ITO film and a film thickness of the oxide film (film thickness of the ITO film/film thickness of the oxide film) is less than 15.

9. The layered body according to claim 8, wherein the oxide film contains Zn in an amount of more than 10 mol% and less than 60 mol% in terms of ZnO, Ga in an amount of 10 mol% or more and 60 mol% or less in terms of Ga₂O₃, and Si in an amount of 25 mol% or more and less than 50 mol% in terms of SiO₂.

10. The layered body according to any one of claims 1 to 9,
wherein the oxide film is amorphous.

11. A method of producing the layered body according to any one of claims 1 to 10, wherein an oxide film is layered on an ITO film, and the obtained layered body is annealed at 200°C or higher.

12. An oxide sputtering target for producing the layered body according to any one of claims 1 to 10, wherein the oxide sputtering target contains Zn in an amount of 0 mol% or more and less than 69 mol% in terms of ZnO, Ga in an amount of 9 mol% or more and 100 mol% or less in terms of Ga₂O₃, and Si in an amount of 0 mol% or more and less than 60 mol% in terms of SiO₂.

13. The oxide sputtering target according to claim 12, wherein the oxide sputtering target contains Zn in an amount of more than 10 mol% and less than 60 mol% in terms of ZnO, Ga in an amount of 10 mol% or more and 60 mol% or less in terms of Ga₂O₃, and Si in an amount of 25 mol% or more and less than 50 mol% in terms of SiO₂.

14. The oxide sputtering target according to claim 12 or claim 13, wherein the oxide sputtering target contains, as a sintering additive, one or more types among B₂O₃, P₂O₅, V₂O₅, Sb₂O₃, TeO₂, TI₂O₃, PbO, Bi₂O₃, and MoO₃.
